(19) Europäisches Patentamt
European Patent Office
Office européen des brevets

(11) **EP 4 567 437 B1**

(12) **FASCICULE DE BREVET EUROPEEN**

(45) Date de publication et mention de la délivrance du brevet:
**11.03.2026 Bulletin 2026/11**

(21) Numéro de dépôt: **24217224.5**

(22) Date de dépôt: **03.12.2024**

(51) Classification Internationale des Brevets (IPC):
**G01R 25/02** (2006.01)   **G01R 27/04** (2006.01)

(52) Classification Coopérative des Brevets (CPC):
**G01R 25/02; G01R 27/04;** G01R 27/08

(54) **MESURE DE LA PHASE D'UNE IMPÉDANCE COMPLEXE PAR SEUILLAGE**

MESSUNG DER PHASE EINER KOMPLEXEN IMPEDANZ DURCH SCHWELLENWERT

MEASUREMENT OF THE PHASE OF A COMPLEX IMPEDANCE BY THRESHOLDING

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **07.12.2023 FR 2313796**

(43) Date de publication de la demande:
**11.06.2025 Bulletin 2025/24**

(73) Titulaire: **Commissariat à l'Energie Atomique et aux Energies Alternatives
75015 Paris (FR)**

(72) Inventeurs:
• **CABANILLAS, Esteban**
**38054 GRENOBLE CEDEX 09 (FR)**
• **GARRAUD, Nicolas**
**38054 GRENOBLE CEDEX 09 (FR)**
• **MARIANNE, Julien**
**38054 GRENOBLE CEDEX 09 (FR)**

(74) Mandataire: **Atout PI Laplace
Immeuble Up On
25 Boulevard Romain Rolland
CS 40072
75685 Paris Cedex 14 (FR)**

(56) Documents cités:
EP-A1- 1 128 371   EP-A2- 3 989 397
CN-A- 111 082 717   FR-A1- 3 009 086
US-A1- 2007 288 183

• PANAGIOTIS KASSANOS ET AL: "A novel front-end for impedance spectroscopy", 2011 IEEE SENSORS PROCEEDINGS : LIMERICK, IRELAND, 28 - 31 OCTOBER 2011, IEEE, PISCATAWAY, NJ, 28 October 2011 (2011-10-28), pages 327 - 330, XP032093556, ISBN: 978-1-4244-9290-9, DOI: 10.1109/ ICSENS.2011.6127367
• TAMADDON MOHSEN ET AL: "An NTF-enhanced time-based continuous-time sigma-delta modulator", ANALOG INTEGRATED CIRCUITS AND SIGNAL PROCESSING, SPRINGER NEW YORK LLC, US, vol. 85, no. 2, 24 May 2015 (2015-05-24), pages 283 - 297, XP035551245, ISSN: 0925-1030, [retrieved on 20150524], DOI: 10.1007/S10470-015-0562-7

**Description**

L'invention se situe dans le domaine de l'instrumentation électronique. Elle porte plus particulièrement sur un procédé et un appareil de mesure d'une impédance complexe d'un élément électrique.

La notion d'impédance complexe généralise celle de résistance pour des signaux sinusoïdaux à une fréquence f donné. Dans le cas d'un dipôle électrique, l'impédance complexe Z est définie par $Z = \frac{U}{I}$ où U est le phaseur (nombre complexe) représentant l'amplitude et la phase de la tension aux bornes du dipôle et I le phaseur représentant l'amplitude et la phase du courant le traversant. Plus généralement, dans le cas d'un circuit à N ports (le dipôle correspondant au cas N=1) on peut définir une impédance $Z_{ij} = \left.\frac{U_i}{I_j}\right|_{I_k=0, k \neq j}$. Autrement dit, l'impédance $Z_{ij}$ est le rapport (complexe) entre le phaseur représentant la tension aux borne du port « i » et le phaseur représentant le courant entrant dans (ou sortant de, en fonction de la convention adoptée) le port « j » lorsque le courant entrant dans tous les autres ports est nul. Les différents termes $Z_{ij}$ forment la matrice impédance de l'élément multiport. Dans la suite, le terme d'impédance et le symbole « Z » seront utilisés pour désigner tant l'impédance d'un dipôle qu'un terme $Z_{ij}$ de la matrice impédance d'un multiport.

Etant un nombre complexe, l'impédance Z peut se décomposer en une partie complexe et une partie imaginaire - Z=R+jX, où « j » désigne ici l'unité imaginaire - ou en module et en phase : $Z = |Z|e^{j\varphi}$, où |Z| est le rapport entre les valeurs efficaces de la tension et du courant et φ leur déphasage.

D'une manière générale, l'impédance varie avec la fréquence des signaux électriques considérés. Pour caractériser un élément électrique il est donc nécessaire de mesurer son (ou ses) impédance(s) dans une bande de fréquence plus ou moins étendue. On écrit donc Z(f), |Z(f)| et φ(f) pour désigner, respectivement, une impédance complexe, son module et sa phase en fonction de la fréquence f.

Plusieurs techniques ont été développées pour mesurer la phase d'une impédance, φ(f), en fonction de la fréquence.

(Angrisani 2001) divulgue un procédé de mesure dans lequel une résistance de valeur connue est connectée en série à l'élément à caractériser et un signal sinusoïdal d'excitation est appliqué audit élément à travers cette résistance. L'impédance de l'élément à caractériser peut être déterminée à partir de la mesure de la tension u(t) du signal d'excitation et de celle, v(t), d'un nœud situé entre la résistance connue et l'élément à caractériser. Plus particulièrement, deux méthodes sont proposées pour déterminer la phase de ladite impédance :

-    Soit les passages par zéro des signaux u(t) et v(t) sont détectés, après avoir filtré ces deux signaux au moyen de filtres prédictifs à réponse impulsionnelle finie pour limiter l'impact du bruit sur la détection du zéro ;
-    Soit le déphasage des deux signaux est calculée à partir de leur produit interne et de leur valeur quadratique moyenne.

(Schröder 2004) détermine aussi la phase d'une impédance complexe en mesurant le déphasage entre deux signaux de tension. Cette mesure de déphasage peut être réalisée par détection des passages par zéro desdits signaux, ou bien par calcul analytique à partir de paramètres d'amplitude et phase desdits signaux, déterminées par interpolation.

FR3009086 divulgue un procédé et dispositif de mesure de la phase de l'impédance complexe d'un élément électrique. Conformément à l'enseignement de ce document, un signal d'excitation à fréquence connue est appliqué à l'élément électrique, puis le déphasage entre le courant qui parcourt ledit dispositif et la tension à ses bornes est mesuré. Pour mesurer ce déphasage, des comparateurs effectuent un seuillage des signaux de tension et de courant pour les convertir d'une forme d'onde sinusoïdale à une en créneaux. Une opération logique appliquée sur les signaux convertis permet de générer des créneaux dont la durée est proportionnelle au décalage temporel entre tension et courant. Ces créneaux pilotent un interrupteur qui charge un condensateur. Après un certain nombre de cycles, on mesure une tension aux bornes du condensateur qui est proportionnelle audit décalage. Un inconvénient de cette approche est sa sensibilité au bruit : en effet, à proximité du franchissement du seuil des commutateurs, le bruit peut induire des commutation multiples.

Les solutions proposées par (Schröder 2004) et (Angrisani 2001) nécessitent la réalisation de calculs assez complexes et, dans le cas de (Angrisani 2001), la mise en œuvre d'un capteur de puissance spécifique.

L'invention vise à surmonter au moins en partie les inconvénients précités de l'art antérieur. Plus spécifiquement, elle vise à permettre une mesure de la phase de l'impédance d'un élément électrique d'une manière particulièrement simple, mettant en œuvre un appareil de faible complexité, pouvant notamment être basé sur un microcontrôleur ou un FPGA.

Un objet de l'invention est un procédé de mesure de la phase de l'impédance complexe d'un élément électrique comprenant les étapes suivantes :

a) appliquer audit élément électrique un signal d'excitation oscillant à une fréquence *f* connue ;

b) acquérir un premier signal analogique, variable au cours du temps, représentatif d'une tension aux bornes de l'élément électrique;

c) acquérir un deuxième signal analogique, variable au cours du temps, représentatif d'un courant à travers l'élément électrique ;

d) déterminer une première valeur numérique représentative d'une amplitude dudit premier signal analogique et une deuxième valeur numérique représentative d'une amplitude dudit deuxième signal analogique ;

e) effectuer un seuillage avec hystérésis dudit premier et dudit deuxième signal analogique ;

f) déterminer une troisième valeur numérique représentative d'un décalage temporel entre un instant de franchissement d'un seuil par ledit premier signal analogique et un instant de franchissement dudit ou d'un autre seuil par ledit deuxième signal analogique ; et

g) déterminer une estimation de ladite phase de l'impédance complexe de l'élément électrique en fonction desdites première, deuxième et troisième valeurs numériques, ainsi que d'une quatrième valeur numérique représentative de la fréquence *f* du signal d'excitation.

- Lors de l'étape e), le seuillage du premier signal analogique peut générer un premier signal en créneau comprenant un premier front montant et un premier front descendant et le seuillage du deuxième signal analogique génère un deuxième signal en créneau comprenant un deuxième front montant et un deuxième front descendant, et l'étape f) peut comprendre une opération de conversion temps - numérique d'un décalage temporel entre le premier et le deuxième front montant, ou entre le premier et le deuxième front descendant.

- L'étape g) comprend :

  g1) la détermination d'une première approximation de ladite phase à partir de ladite troisième valeur numérique représentative d'un décalage temporel et de ladite quatrième valeur numérique représentative de la fréquence f du signal d'excitation ;

  g2) la détermination d'un terme de correction de phase en fonction de la première et de la deuxième valeur numérique ;

  g3) la détermination de ladite estimation de la phase de l'impédance complexe de l'élément électrique par calcul de la somme ladite première approximation et dudit terme de correction de phase.

Selon des modes de réalisation particuliers d'un tel procédé :

- Ladite quatrième valeur numérique peut être déterminée par calcul du produit entre ladite troisième valeur numérique représentative d'un décalage temporel et ladite quatrième valeur numérique représentative de la fréquence *f* du signal d'excitation.

- La détermination dudit terme de correction de phase peut être également effectuée en fonction d'une cinquième valeur numérique représentative d'un dit seuil.

- La détermination d'un terme de correction de phase peut être effectuée au moyen d'une table de correspondance.

Un autre objet de l'invention est un appareil de mesure de la phase d'une impédance complexe d'un élément électrique comprenant :

- un premier convertisseur analogique - numérique configuré pour recevoir en entrée un premier signal analogique variable au cours du temps, représentatif d'une tension entre deux bornes de l'élément électrique, et le convertir en un premier signal numérique ;

- un deuxième convertisseur analogique - numérique configuré pour recevoir un deuxième signal analogique variable au cours du temps, représentatif d'un courant à travers l'élément électrique, et le convertir en un deuxième signal numérique ;

- une première bascule de Schmitt pour génère un premier signal en créneau par seuillage dudit premier signal analogique ;

- une deuxième bascule de Schmitt pour génère un deuxième signal en créneau par seuillage dudit deuxième signal analogique ; et

- un circuit numérique configuré pour déterminer une estimation de ladite phase de l'impédance complexe de l'élément électrique en fonction d'une première valeur numérique représentative d'une amplitude dudit premier signal numérique, d'une deuxième valeur numérique représentative d'une amplitude dudit deuxième signal numérique, d'une troisième valeur numérique représentative d'un décalage temporel entre le premier signal en créneau et le deuxième signal en créneau et d'une quatrième valeur numérique représentative de la fréquence $f$ du signal d'excitation.

Ledit circuit numérique comprend :

- un convertisseur temps - numérique pour déterminer ladite troisième valeur numérique ;
- un module de calcul pour déterminer une première approximation de ladite phase à partir de ladite troisième valeur numérique et d'une quatrième valeur numérique représentative d'une fréquence f desdits premier et dudit deuxième signal analogique ;
- une table de correspondance pour déterminer un terme de correction de phase en fonction de la première et de la deuxième valeur numérique ; et
- un module additionneur pour déterminer ladite estimation de ladite phase de l'impédance complexe de l'élément électrique par calcul de la somme ladite première approximation et dudit terme de correction de phase.

Selon des modes de réalisation particuliers d'un tel appareil

- L'appareil peut comprendre également un troisième convertisseur numérique - analogique pour générer une cinquième valeur numérique représentatif d'une tension de seuil commune auxdites première et deuxième bascule de Schmitt, ladite table de correspondance étant configurée pour déterminer ledit terme de correction de phase en fonction de la première, de la deuxième et de la cinquième valeur numérique.
- Ledit circuit numérique peut être également configuré pour recevoir en entrée ladite cinquième valeur numérique.

D'autres caractéristiques, détails et avantages de l'invention ressortiront à la lecture de la description faite en référence aux dessins annexés donnés à titre d'exemple et qui représentent, respectivement :

[Fig.1], le schéma fonctionnel d'un appareil de mesure ne relevant pas de l'invention ;

[Fig. 2], une illustration du principe de fonctionnement de l'appareil de la [Fig. 1] ;

[Fig. 3], une illustration de l'erreur de mesure de phase induit par une différence d'amplitude des signaux d'entrée ;

[Fig. 4] et [Fig. 5] des graphiques illustrant la dépendance dudit erreur de mesure de phase en fonction de la tension de seuil pour différents valeurs d'amplitude du signal représentatif du courant à travers l'élément électrique et une même valeur d'amplitude du signal représentatif de la tension à ses bornes ; et

[Fig. 6], le schéma fonctionnel d'un appareil de mesure selon un mode de réalisation de l'invention.

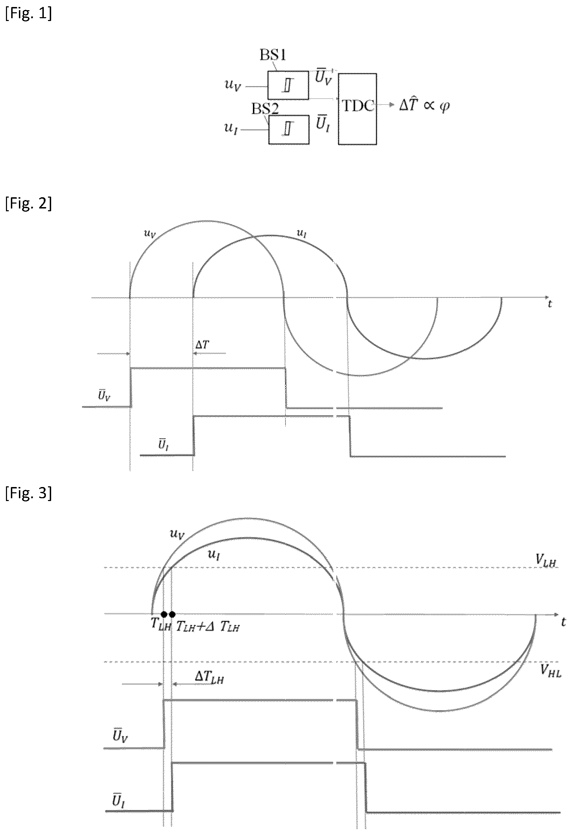

La [Fig. 1] est le schéma fonctionnel d'un hypothétique appareil de mesure permettant, en principe, de mesurer le déphasage entre deux signaux analogiques sinusoïdaux $U_V$ et $u_I$. Si ces deux signaux sont représentatifs, respectivement, de la tension aux bornes d'un élément électrique et du courant le traversant, cette mesure de déphasage permet de déterminer la phase de l'impédance complexe de l'élément.

L'appareil de la [Fig. 1] comprend deux bascules de Schmitt BS1, BS2 présentant deux tensions de seuil $V_{LH} > 0$ V et $V_{HL} < 0$ V. La sortie d'une bascule de Schmitt devient haute lorsque le signal à son entrée dépasse $V_{LH}$, puis se maintient haute tant que ledit signal de descend en dessous de $V_{HL}$. Pour $V_{LH} \to 0$ V et $V_{HL} \to 0$ V, la bascule de Schmitt devient un simple comparateur à zéro. Si un tel comparateur était utilisé, comme dans le cas du document FR3009086 précité, le bruit électronique induirait des commutations multiples et aléatoires lors d'un passage par zéro du signal d'entrée ; pour cette raison on préfère généralement utiliser des bascules de Schmitt - dites aussi comparateurs à hystérésis - avec une hystérésis $\Delta V = V_{LH} - V_{HL}$ du même ordre de grandeur que l'amplitude de pic du bruit affectant le signal d'entrée.

Les bascules de Schmitt convertissent les signaux sinusoïdaux d'entrée $u_V$ et $u_I$ en deux signaux en créneaux $\overline{U}_V$ et $\overline{U}_I$ respectivement. Un convertisseur temps - numérique TDC (« time-to-digital converter » en anglais) reçoit en entrée ces signaux et fournit à sa sortie une valeur numérique $\Delta \hat{T}$ qui constitue une estimation du décalage temporel $\Delta T$ entre les fronts montants (ou, de manière équivalente, les fronts descendants) de ces signaux. Comme on peut le voir sur la [Fig. 2], ce décalage temporel est à son tour proportionnel au déphasage $\varphi$ entre les deux signaux analogiques d'entrée $u_V$ et $u_I$. Aussi, la sortie numérique du convertisseur TDC constitue (à un facteur multiplicatif près, égal à la fréquence $f$ des signaux d'entrée) une estimation $\hat{\varphi}$ de ce déphasage.

Un inconvénient de l'utilisation des bascules de Schmitt à la place de simples comparateurs à zéro est que l'instant franchissement du seuil $V_{LH}$ (ou $V_{HL}$ si on s'intéresse aux fronts descendants) ne dépend pas uniquement de la phase des signaux d'entrée, mais aussi de leur amplitude. Aussi, une différence d'amplitude des signaux $u_V$ et $u_I$ faussera la mesure de leur déphasage. Cela est illustré dans le cas de la [Fig. 3], où les signaux $u_V$ et $u_I$ sont parfaitement en phase entre eux, mais pas de même amplitude. On peut constater que le signal le plus intense, $u_V$, franchit le seul $V_{LH}$ à un temps t= $T_{LH}$, tandis que le signal le moins intense, $u_I$, le franchit plus tard, à un instant T=$T_{LH}$+ $\Delta T_{LH}$. Le décalage temporel $\Delta T_{LH}$ induit par la différence d'amplitude de $u_V$ et $u_I$ conduit à une estimation $\hat{\varphi}$ non nulle du déphasage entre ces deux signaux, qui sont en réalité en phase entre eux. Plus précisément on trouve $\hat{\varphi} = \Delta\hat{\varphi}_{LH} = f\Delta T_{LH}$, $f$ étant la fréquence des signaux d'entrée.

La situation ne change pas si le déphasage $\varphi$ entre les deux signaux d'entrée est effectivement non-nul : la différence entre leurs amplitudes introduit une erreur d'estimation $\Delta\hat{\varphi}_{LH}$ dudit déphasage.

L'erreur d'estimation de phase $\Delta\hat{\varphi}_{LH}$ peut être calculée en analysant les signaux autour du temps $T_{LH}$ :

$$V_{LH} = A\,cos(\omega T_{LH}) \leftrightarrow T_{LH} = \frac{1}{\omega}\,cos^{-1}\left(\frac{V_{LH}}{A}\right) \tag{1}$$

$$V_{LH} = B\,cos\big(\omega(T_{LH} + \Delta T_{LH})\big) \leftrightarrow \Delta T_{LH} = \frac{1}{\omega}\left(cos^{-1}\left(\frac{V_{LH}}{B}\right)\right) - T_{LH} \tag{2}$$

où $A$ et $B$ sont les amplitudes (réelles) des signaux analogiques sinusoïdaux $u_V$ et $u_i$, et $\omega$ la pulsation des signaux, $\omega = 2\pi f$.

En supprimant $T_{LH}$ des deux équations précédentes on obtient :

$$\Delta T_{LH} = \frac{1}{\omega}\left(cos^{-1}\left(\frac{V_{LH}}{B}\right) - cos^{-1}\left(\frac{V_{LH}}{A}\right)\right) \tag{3}$$

L'erreur de phase $\Delta\varphi_{LH}$ est donc donnée par :

$$\Delta\hat{\varphi}_{LH} = cos^{-1}\left(\frac{V_{LH}}{B}\right) - cos^{-1}\left(\frac{V_{LH}}{A}\right) \tag{4}$$

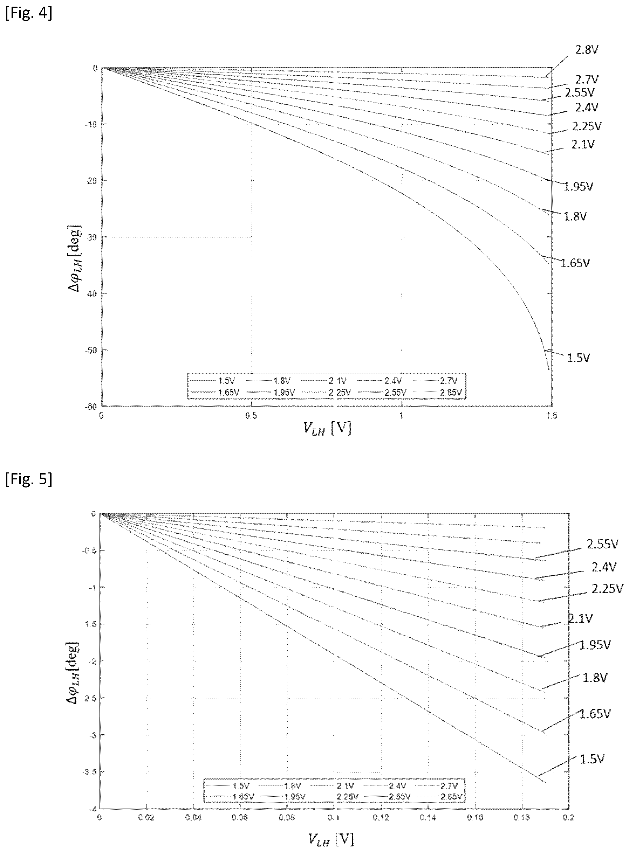

[Fig. 4] est un graphique de l'erreur de phase $f_{\varphi LH}$ en fonction de la tension de seuil $V_{LH}$ pour différentes valeurs de l'amplitude B allant de 1,5V à 2,85V, tandis que l'amplitude A est considérée fixée à 3V. Dans le cas où l'écart signal à bruit (SNR, de l'anglais « Signal-to-Noise Ratio ») des signaux d'entrée n'est pas trop élevé - par exemple SNR > 25 dB - on peut prendre $V_{LH}$ faible devant A et B, par exemple $V_{LH}$<0,2V. Dans ces conditions, $\Delta\varphi_{LH}$ peut être approché par une fonction linéaire, comme illustré par la [Fig. 5].

En effet, en développant l'expression de $\Delta\varphi_{LH}$ obtenue plus haut en série de Taylor au premier ordre autour de $V_{LH} = 0$ on trouve

$$\Delta\hat{\varphi}_{LH} = cos^{-1}\left(\frac{V_{LH}}{B}\right) - cos^{-1}\left(\frac{V_{LH}}{A}\right) \sim \left(\frac{\pi}{2} - \frac{V_{LH}}{B}\right) - \left(\frac{\pi}{2} - \frac{V_{LH}}{A}\right) = \frac{V_{LH}}{A} - \frac{V_{LH}}{B} =$$

$$\left(\frac{1}{A} - \frac{1}{B}\right)V_{LH} \tag{5}$$

Une idée à la base de l'invention est que l'erreur $\Delta\varphi_{LH}$ peut être pré-calculée en fonction des amplitudes A et B et de la tension de seuil $V_{LH}$, grandeurs qui peuvent être aisément mesurées à l'aide de convertisseurs analogique - numériques ($V_{LH}$ peut aussi être considéré connu par conception du système). Cela permet de compenser ladite erreur pour obtenir une estimation améliorée du déphasage entre les signaux d'entrée :

$$\widehat{\varphi'} = \hat{\varphi} - \Delta\hat{\varphi}_{LH} \tag{6}$$

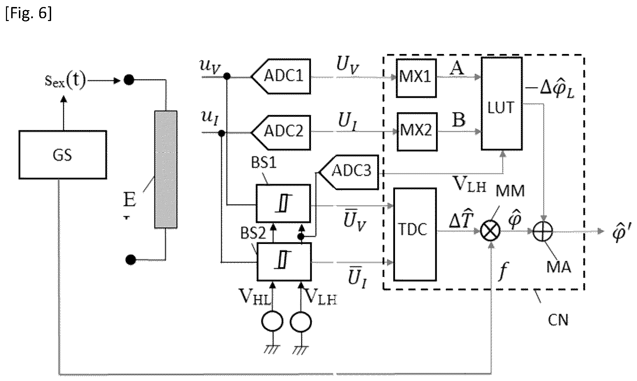

La [Fig. 6] illustre le schéma fonctionnel d'un appareil selon un mode de réalisation de l'invention, mettant en œuvre ce principe.

Sur la [Fig. 6], la référence EL représente un élément électrique (plus particulièrement, un dipôle, comprenant deux bornes formant un seul port) dont la phase de l'impédance complexe doit être déterminée. Un générateur GS applique un signal d'excitation $s_{ext}(t)$ sinusoïdal, de fréquence $f$ éventuellement variable, aux bornes de l'élément EL. Le signal $s_{ext}(t)$ peut être un signal de courant ou de tension. Le générateur GS fournit également à sa sorte une valeur numérique représentative de la fréquence $f$. Le générateur GS peut, par exemple, être piloté de telle sorte que $f$ balaye, de manière continue ou discrète, une bande spectrale d'intérêt.

L'appareil de la [Fig. 6] reçoit sur un premier port d'entré le premier signal analogique $u_V(t)$ représentatif de la tension aux bornes de l'élément EL et sur un deuxième port d'entré le deuxième signal analogique $u_I(t)$ représentatif du courant traversant ce dernier. Par exemple, le signal $u_V(t)$ peut être directement la tension aux bornes de l'élément EL et $u_I(t)$ une tension aux bornes d'une résistance connectée en série à EL. Un premier convertisseur analogique - numérique ADC1 échantillonne et convertit le signal analogique $u_V$ en un signal numérique $U_V$. De même, un second convertisseur analogique - numérique ADC2 échantillonne convertit le signal analogique $u_I$ en un signal numérique $U_I$.

Les signaux $u_V(t)$ et $u_I(t)$ sont également fournis en entrée à des bascules de Schmitt respectives BS1, BS2, qui fournissent en sortie des signaux en créneau $\overline{U}_V$, $\overline{U}_I$. Comme expliqué plus haut, en référence à la [Fig. 2] et à la [Fig. 3], les fronts montants de ces signaux en créneau correspondent au franchissement d'un seuil $V_{LH}$ dans le sens croissant par $u_V(t)$ et $u_I(t)$ respectivement, tandis que leurs fronts descendants correspondent au franchissement d'un seuil $V_{HL} < V_{LH}$ dans le sens décroissant par ces mêmes signaux. Les seuils $V_{HL}$ et $V_{LH}$ sont fixés par des valeurs de tension fournies en entrée aux bascules de Schmitt BS1, BS2. La tension $V_{LH}$, en outre, est convertie au format numérique par un troisième convertisseur analogique - numérique ADC3.

Les signaux numériques $U_V$, $U_I$, $V_{TH}$ et $f$, ainsi que les signaux en créneau $\overline{U}_V$, $\overline{U}_I$, sont fournis en entrée à un circuit numérique CN qui s'en sert pour calculer une estimation $\hat{\varphi}'$ du déphasage entre les signaux $u_V(t)$ et $u_I(t)$ - c'est-à-dire de la phase de l'impédance complexe de l'élément électrique EL.

Le circuit numérique CN comprend un convertisseur temps-numérique TDC qui reçoit en entrée les signaux en créneau $\overline{U}_V$, $\overline{U}_I$ et - comme expliqué plus haut en référence à la [Fig. 1] - génère une valeur numérique $\Delta\hat{T}$ représentative d'un décalage temporel entre leurs fronts montants. Un module multiplicateur MM calcule le produit de $\Delta\hat{T}$ par la fréquence $f$ pour déterminer une première estimation $\hat{\varphi}$ du déphasage $\varphi$ entre les signaux $u_V(t)$ et $u_I(t)$, et donc de la phase de l'impédance complexe de l'élément EL.

Le circuit numérique CN comprend également deux blocs logiques MX1, MX2 configurés pour extraire des signaux numériques $\overline{U}_V$ et $U_I$, les valeurs A et B représentatives de l'amplitude des signaux analogiques $u_V(t)$ et $u_I(t)$. Par exemple, les blocs MX1, MX2 peuvent déterminer des extrema locaux desdits signaux et en moyenner les valeurs, ou les interpoler avec des fonctions sinusoïdales parfaites.

Les valeurs numériques A, B et $V_{LH}$ (ce dernier, issu du troisième convertisseur analogique - numérique ADC3) permettent de calculer le terme de correction $-\Delta\hat{\varphi}_{LH}$ par application de l'équation (4), de son approximation linéaire (5) ou d'une approximation polynomiale. Le calcul est typiquement effectué au moyen d'une table de correspondance à trois entrée LUT.

Enfin, un module additionneur MA calcule une estimation corrigée $\hat{\varphi}'$ en appliquant le terme de correction $\Delta\hat{\varphi}_{LH}$ à la première estimation $\hat{\varphi}$.

L'invention a été décrite en référence à un mode de réalisation particulier, mais des variantes sont possibles. Par exemple :

- Le circuit numérique CN peut être mis en œuvre au moyen d'un microprocesseur programmé de manière opportune (auquel cas les différents « blocs » et « modules » de la [Fig. 6] sont réalisés de manière logicielle), un FPGA ou un ASIC.

- La table de correspondance LUT peut être réalisée au moyen d'un dispositif de mémoire dédié, ou constituer une région d'une mémoire d'un microprocesseur.

- La détermination du terme de correction $\Delta\hat{\varphi}_{LH}$ peut être effectuée par un circuit arithmétique (dans le cas d'une réalisation par FPGA ou ASIC) ou par une routine de calcul (dans le cas d'une réalisation logicielle), au lieu d'une table de correspondance, particulièrement si l'approximation linéaire de l'équation (5) est utilisée.

- Les blocs MX1, MX2 peuvent être omis si un détecteur de crête est prévu en amont de chacun des convertisseurs analogique-numérique ADC1, ADC2

- Au lieu du décalage temporel entre les fronts montants des signaux $U_V$ et $U_I$, il est possible de prendre en compte les fronts descendants. Dans ce cas, c'est le seuil $V_{HL}$ qui doit être utilisé pour le calcul du terme de correction.

- La valeur du seuil $V_{LH}$ (ou $V_{HL}$ si on s'intéresse aux fronts descendants) peut être prédéfinie et stockée dans une mémoire, au lieu d'être acquise et convertie au format numérique. L'utilisation d'un convertisseur analogique - numérique ADC3, comme dans le mode de réalisation de la [Fig. 3], est cependant avantageuse car elle permet de tenir compte des dérives.

- De même, la fréquence $f$ peut être une valeur prédéfinie stockée dans une mémoire, au lieu d'être fournie par le générateur FS. Inversement, elle peut aussi être déterminée à partir des signaux analogiques $u_V(t)$ et $u_I(t)$.

- Plusieurs réalisation connues de l'homme du métier sont possibles pour le convertisseur temps-numérique TDC : un simple compteur à haute fréquence, un compteur avec une ligne de retardement, un circuit à double ligne de retardement, etc.

Références

(Angrisani 2001): L. Angrisani, L. Ferrigno, Reducing the uncertainty in realtime impedance measurements, Measurement, Volume 30, Issue 4, 2001, Pages 307-315,
**[0039]**    (Schröder 2004): Jens Schröder and Steffen Doerner and Thomas Schneider and Peter Hauptmann, Analogue and digital sensor interfaces for impedance spectroscopy, Measurement Science and Technology, Volume 15, Issue 7, 2004, Pages 1271 - 1278

## Revendications

1. Procédé de mesure de la phase de l'impédance complexe d'un élément électrique (EL) comprenant les étapes suivantes :

   a) appliquer audit élément électrique (EL) un signal d'excitation ($s_{ex}$) oscillant à une fréquence $f$ connue ;
   b) acquérir un premier signal analogique ($u_V$), variable au cours du temps, représentatif d'une tension aux bornes de l'élément électrique;
   c) acquérir un deuxième signal analogique ($u_I$), variable au cours du temps, représentatif d'un courant à travers l'élément électrique ;
   d) déterminer une première valeur numérique (A) représentative d'une amplitude dudit premier signal analogique ($u_V$) et une deuxième valeur numérique (B) représentative d'une amplitude dudit deuxième signal analogique ($u_I$) ;
   e) effectuer un seuillage avec hystérésis dudit premier et dudit deuxième signal analogique ;
   f) déterminer une troisième valeur numérique ($\Delta\hat{T}$) représentative d'un décalage temporel entre un instant de franchissement d'un seuil par ledit premier signal analogique et un instant de franchissement dudit ou d'un autre seuil par ledit deuxième signal analogique ; et
   g) déterminer une estimation ($\hat{\varphi}'$) de ladite phase de l'impédance complexe de l'élément électrique en fonction desdites première, deuxième et troisième valeurs numériques, ainsi que d'une quatrième valeur numérique représentative de la fréquence $f$ du signal d'excitation ; dans lequel l'étape g) comprend :

      g1) la détermination d'une première approximation ($\hat{\varphi}$) de ladite phase ($\varphi$) à partir de ladite troisième valeur numérique ($\Delta\hat{T}$) représentative d'un décalage temporel et de ladite quatrième valeur numérique représentative de la fréquence $f$ du signal d'excitation ;
      g2) la détermination d'un terme de correction de phase ($-\Delta\hat{\varphi}_{LH}$) en fonction de la première et de la deuxième valeur numérique ;
      g3) la détermination de ladite estimation ($\hat{\varphi}'$) de la phase de l'impédance complexe de l'élément électrique par calcul de la somme ladite première approximation et dudit terme de correction de phase. .

2. Procédé selon la revendication 1 dans lequel, lors de l'étape e), le seuillage du premier signal analogique génère un premier signal en créneau ($\overline{U}_V$) comprenant un premier front montant et un premier front descendant et le seuillage du deuxième signal analogique génère un deuxième signal en créneau ($\overline{U}_I$) comprenant un deuxième front montant et un deuxième front descendant, et dans lequel l'étape f) comprend une opération de conversion temps - numérique d'un décalage temporel ($\Delta T_{LH}$) entre le premier et le deuxième front montant, ou entre le premier et le deuxième front descendant.

3. Procédé selon l'une des revendications précédentes dans lequel ladite quatrième valeur numérique est déterminée par calcul du produit entre ladite troisième valeur numérique ($\Delta\hat{T}$) représentative d'un décalage temporel et ladite quatrième valeur numérique représentative de la fréquence *f* du signal d'excitation.

4. Procédé selon l'une des revendications précédentes dans lequel la détermination dudit terme de correction de phase ($-\Delta\varphi_{LH}$) est également effectuée en fonction d'une cinquième valeur numérique ($V_{LH}$) représentative d'un dit seuil.

5. Procédé selon l'une des revendications précédentes dans lequel la détermination d'un terme de correction de phase ($--\Delta\varphi_{LH}$) est effectuée au moyen d'une table de correspondance (LUT).

6. Appareil de mesure de la phase d'une impédance complexe d'un élément électrique (EL) comprenant :

- un premier convertisseur analogique - numérique (ADC1) configuré pour recevoir en entrée un premier signal analogique ($u_V$), variable au cours du temps, représentatif d'une tension entre deux bornes de l'élément électrique, et le convertir en un premier signal numérique ($U_V$) ;
- un deuxième convertisseur analogique - numérique (ADC2) configuré pour recevoir un deuxième signal analogique ($u_I$), variable au cours du temps, représentatif d'un courant à travers l'élément électrique, et le convertir en un deuxième signal numérique ($U_I$) ;
- une première bascule de Schmitt (BS1) pour génère un premier signal en créneau ($\overline{U}_V$) par seuillage dudit premier signal analogique ;
- une deuxième bascule de Schmitt (BS2) pour génère un deuxième signal en créneau ($\overline{U}_I$) par seuillage dudit deuxième signal analogique ;
et
- un circuit numérique (CN) configuré pour déterminer une estimation ($\hat{\varphi}'$) de ladite phase de l'impédance complexe de l'élément électrique en fonction d'une première valeur numérique (A) représentative d'une amplitude dudit premier signal numérique ($U_V$), d'une deuxième valeur numérique (B) représentative d'une amplitude dudit deuxième signal numérique ($U_I$), d'une troisième valeur numérique ($\Delta\hat{T}$) représentative d'un décalage temporel entre le premier signal en créneau ($\overline{U}_V$) et le deuxième signal en créneau ($\overline{U}_V$) et d'une quatrième valeur numérique représentative de la fréquence *f* du signal d'excitation ;

dans lequel ledit circuit numérique comprend :

- un convertisseur temps - numérique (TDC) pour déterminer ladite troisième valeur numérique ($\Delta\hat{T}$) ;
- un module de calcul pour déterminer une première approximation ($\hat{\varphi}$) de ladite phase ($\varphi$) à partir de ladite troisième valeur numérique ($\Delta\hat{T}$) et d'une quatrième valeur numérique représentative d'une fréquence *f* desdits premier et dudit deuxième signal analogique ;
- une table de correspondance pour déterminer un terme de correction de phase ($-\Delta\varphi_{LH}$) en fonction de la première et de la deuxième valeur numérique ; et
- un module additionneur pour déterminer ladite estimation ($\hat{\varphi}'$) de ladite phase de l'impédance complexe de l'élément électrique par calcul de la somme ladite première approximation et dudit terme de correction de phase.

7. Appareil selon la revendication 6 comprenant également un troisième convertisseur numérique - analogique (ADC3) pour générer une cinquième valeur numérique ($V_{LH}$) représentatif d'une tension de seuil commune auxdites première et deuxième bascule de Schmitt, ladite table de correspondance (LUT) étant configurée pour déterminer ledit terme de correction de phase ($-\Delta\varphi_{PLH}$) en fonction de la première, de la deuxième et de la cinquième valeur numérique.

8. Appareil selon l'une des revendications 6 ou 7 dans lequel ledit circuit numérique (CN) est également configuré pour recevoir en entrée ladite cinquième valeur numérique ($V_{LH}$).

**Patentansprüche**

1. Verfahren zum Messen der Phase der komplexen Impedanz eines elektrischen Elements (EL), umfassend die folgenden Schritte:

a) Anwenden eines Anregungssignals ($s_{ex}$), das mit einer bekannten Frequenz*f* oszilliert, auf das elektrische Element (EL);
b) Erfassen eines ersten sich mit der Zeit ändernden analogen Signals ($u_v$), das repräsentativ für eine Spannung an den Klemmen des elektrischen Elements;
c) Erfassen eines zweiten sich mit der Zeit ändernden analogen Signals ($u_I$), das repräsentativ für einen Strom durch das elektrische Element hindurch ist;

d) Bestimmen eines ersten digitalen Werts (A), der repräsentativ für eine Amplitude des ersten analogen Signals ($u_v$) ist, und eines zweiten digitalen Werts (B), der repräsentativ für eine Amplitude des zweiten analogen Signals ($u_j$) ist;

e) Durchführen einer Schwellenwertanwendung mit Hysterese des ersten und des zweiten analogen Signals,

f) Bestimmen eines dritten digitalen Werts ($\Delta\hat{T}$), der repräsentativ für eine zeitliche Verschiebung zwischen einem Zeitpunkt der Überschreitung eines Schwellenwerts durch das erste analoge Signal und einem Zeitpunkt der Überschreitung des einen oder eines anderen Schwellenwerts durch das zweite analoge Signal ist; und

g) Bestimmen einer Schätzung ($\hat{\varphi}'$) der Phase der komplexen Impedanz des elektrischen Elements in Abhängigkeit von dem ersten, zweiten und dritten digitalen Wert sowie einem vierten digitalen Wert, der repräsentativ für die Frequenz $f$ des Anregungssignals ist, wobei der Schritt g) Folgendes umfasst:

g1) die Bestimmung einer ersten Annäherung ($\hat{\varphi}$) der Phase ($\varphi$) ausgehend von dem dritten digitalen Wert ($\Delta\hat{T}$), der repräsentativ für eine zeitliche Verschiebung ist, und dem vierten digitalen Wert, der repräsentativ für die Frequenz $f$ des Anregungssignals ist;

g2) die Bestimmung eines Phasenkorrekturterms ($-\Delta\varphi_{LH}$) in Abhängigkeit von dem ersten und dem zweiten digitalen Wert;

g3) die Bestimmung der Schätzung ($\widehat{\varphi'}$) der Phase der komplexen Impedanz des elektrischen Elements durch Berechnung der Summe aus der ersten Annäherung und dem Phasenkorrekturterm.

2. Verfahren nach Anspruch 1, wobei beim Schritt e) die Schwellenwertanwendung des ersten analogen Signals ein erstes Signal im Zeitfenster ($\overline{U}_V$) erzeugt, das eine erste steigende Flanke und eine erste fallende Flanke umfasst, und die Schwellenwertanwendung des zweiten analogen Signals ein zweites Signal im Zeitfenster ($\overline{U}_I$) erzeugt, das eine zweite steigende Flanke und eine zweite fallende Flanke umfasst, und wobei der Schritt f) einen Vorgang der Zeit-Digital-Umwandlung einer zeitlichen Verschiebung ($\Delta T_{LH}$) zwischen der ersten und der zweiten steigenden Flanke oder zwischen der ersten und der zweiten fallenden Flanke umfasst.

3. Verfahren nach einem der vorstehenden Ansprüche, wobei der vierte digitale Wert durch Berechnung des Produkts zwischen dem dritten digitalen Wert ($\Delta\hat{T}$), der repräsentativ für eine zeitliche Verschiebung ist, und dem vierten digitalen Wert, der repräsentativ für die Frequenz $f$ des Anregungssignals ist, bestimmt wird.

4. Verfahren nach einem der vorstehenden Ansprüche, wobei die Bestimmung des Phasenkorrekturterms ($-\Delta\varphi_{LH}$) ebenfalls in Abhängigkeit von einem fünften digitalen Wert ($V_{LH}$), der repräsentativ für einen Schwellenwert ist, durchgeführt wird.

5. Verfahren nach einem der vorstehenden Ansprüche, wobei die Bestimmung eines Phasenkorrekturterms ($-\Delta\varphi_{LH}$) mittels einer Entsprechungstabelle (LUT) durchgeführt wird.

6. Einrichtung zum Messen der Phase einer komplexen Impedanz eines elektrischen Elements (EL), umfassend:

- einen ersten Analog-Digital-Wandler (ADC1), der konfiguriert ist, um als Eingang ein erstes sich mit der Zeit änderndes analoges Signal ($u_v$) zu empfangen, das repräsentativ für eine Spannung zwischen zwei Klemmen des elektrischen Elements ist, und es in ein erstes digitales Signal ($\overline{U}_V$) umzuwandeln;

- einen zweiten Analog-Digital-Wandler (ADC2), der konfiguriert ist, um ein zweites sich mit der Zeit änderndes analoges Signal ($\overline{U}_I$) zu empfangen, das repräsentativ für einen Strom durch das elektrische Element ist, und es in ein zweites digitales Signal ($U_I$) umzuwandeln;

- einen ersten Schmitt-Trigger (BS1), um ein erstes Signal im Zeitfenster ($\overline{U}_V$) durch Schwellenwertanwendung des ersten analogen Signals zu erzeugen;

- einen zweiten Schmitt-Trigger (BS2), um ein zweites Signal im Zeitfenster ($\overline{U}_I$) durch Schwellenwertanwendung des zweiten analogen Signals zu erzeugen; und

- eine digitale Schaltung (CN), die konfiguriert ist zum Bestimmen einer Schätzung ($\hat{\varphi}'$) der Phase der komplexen Impedanz des elektrischen Elements in Abhängigkeit von einem ersten digitalen Wert (A), der repräsentativ für eine Amplitude des ersten digitalen Signals ($\overline{U}_V$) ist, einem zweiten digitalen Wert (B), der repräsentativ für eine Amplitude des zweiten digitalen Signals ($\overline{U}_I$) ist, einem dritten digitalen Wert ($\Delta\hat{T}$), der repräsentativ für eine zeitliche Verschiebung zwischen dem ersten Signal im Zeitfenster ($\overline{U}_V$) und dem zweiten Signal im Zeitfenster ($\overline{U}_V$) ist, und einem vierten digitalen Wert, der repräsentativ für die Frequenz $f$ des Anregungssignals ist;

wobei die digitale Schaltung Folgendes umfasst:

- einen Zeit-Digital-Wandler (TDC) zum Bestimmen des dritten digitalen Werts ($\Delta\hat{T}$);
- ein Berechnungsmodul zum Bestimmen einer ersten Annäherung ($\hat{\varphi}$) der Phase ($\hat{\varphi}$) ausgehend von dem dritten digitalen Wert ($\Delta\hat{T}$) und einem vierten digitalen Wert, der repräsentativ für eine Frequenz f des ersten und des zweiten analogen Signals ist;
- eine Entsprechungstabelle zum Bestimmen eines Phasenkorrekturterms ($-\Delta\varphi_{LH}$) in Abhängigkeit von dem ersten und dem zweiten digitalen Wert; und
- ein Summierungsmodul zum Bestimmen der Schätzung ($\hat{\varphi}'$) der Phase der komplexen Impedanz des elektrischen Elements durch Berechnung der Summe aus der ersten Annäherung und dem Phasenkorrekturterm.

7. Einrichtung nach Anspruch 6, die ebenfalls einen dritten Analog-Digital-Wandler (ADC3) umfasst, um einen fünften digitalen Wert ($V_{LH}$) zu erzeugen, der repräsentativ für eine Schwellenwertspannung ist, die dem ersten und zweiten Schmitt-Trigger gemein ist, wobei die Entsprechungstabelle (LUT) konfiguriert ist, um den Phasenkorrekturterm ($-\Delta\varphi_{LH}$) in Abhängigkeit von dem ersten, dem zweiten und dem fünften digitalen Wert zu bestimmen.

8. Einrichtung nach einem der Ansprüche 6 oder 7, wobei die digitale Schaltung (CN) ebenfalls konfiguriert ist, um den fünften digitalen Wert ($V_{LH}$) zu empfangen.

**Claims**

1. Method for measuring the phase of the complex impedance of an electrical element (EL) comprising the following steps:

a) applying to said electrical element (EL) an excitation signal ($S_{ex}$) oscillating at a known frequency f;
b) acquiring a first analog signal ($u_v$), variable over time, representative of a voltage at the terminals of the electrical element;
c) acquiring a second analog signal ($u_l$), variable over time, representative of a current through the electrical element;
d) determining a first digital value (A) representative of an amplitude of said first analog signal ($u_v$) and a second digital value (B) representative of an amplitude of said second analog signal ($u_l$);
e) performing a thresholding with hysteresis on said first and said second analog signals;
f) determining a third digital value ($\Delta\hat{T}$) representative of a time shift between a crossing instant of a threshold by said first analog signal and a crossing instant of said or another threshold by said second analog signal; and
g) determining an estimate ($\hat{\varphi}'$) of said phase of the complex impedance of the electrical element based on said first, second, and third digital values, as well as a fourth digital value representative of the frequency f of the excitation signal; wherein step g) comprises:

g1) determining a first approximation ($\hat{\varphi}$) of said phase ($\hat{\varphi}$) from said third digital value ($\Delta\hat{T}$) representative of a time shift and said fourth digital value representative of the frequency f of the excitation signal;
g2) determining a phase correction term ($-\Delta\varphi_{LH}$) based on the first and second digital values;
g3) determining said estimate ($\hat{\varphi}'$) of the phase of the complex impedance of the electrical element by calculating the sum of said first approximation and said phase correction term.

2. Method according to claim 1, wherein, during step e), the thresholding of the first analog signal generates a first stepped signal ($\overline{U}_v$) comprising a first rising edge and a first falling edge, and the thresholding of the second analog signal generates a second stepped signal ($\overline{U}_l$) comprising a second rising edge and a second falling edge, and wherein step f) comprises a time-to-digital conversion operation of a time offset ($\Delta T_{LH}$) between the first and second rising edges, or between the first and second falling edges.

3. Method according to one of the preceding claims, wherein said fourth digital value is determined by calculating the product between said third digital value ($\Delta\hat{T}$) representative of a time offset and said fourth digital value representative of the frequency f of the excitation signal.

4. Method according to one of the preceding claims, wherein the determination of said phase correction term ($-\Delta\varphi_{LH}$) is also performed as based on a fifth digital value ($V_{LH}$) representative of a said threshold.

5. Method according to one of the preceding claims, wherein the determination of a phase correction term ($-\Delta\varphi_{LH}$) is performed by means of a lookup table (LUT).

6. Apparatus for measuring the phase of a complex impedance of an electrical element (EL) comprising:

   - a first analog-to-digital converter (ADC1) configured to receive as input a first analog signal ($u_V$), variable over time, representative of a voltage between two terminals of the electrical element, and convert it into a first digital signal ($U_V$);
   - a second analog-to-digital converter (ADC2) configured to receive a second analog signal ($u_I$), variable over time, representative of a current through the electrical element, and convert it into a second digital signal ($U_I$);
   - a first Schmitt trigger (BS1) for generating a first pulse signal ($\overline{U}_V$) by thresholding said first analog signal;
   - a second Schmitt trigger (BS2) for generating a second pulse signal ($\overline{U}_I$) by thresholding said second analog signal;
   and
   - a digital circuit (CN) configured to determine an estimate ($\hat{\varphi}'$) of said phase of the complex impedance of the electrical element based on a first digital value (A) representative of an amplitude of said first digital signal ($U_V$), a second digital value (B) representative of an amplitude of said second digital signal ($U_I$), a third digital value ($\Delta\hat{T}$) representative of a time shift between the first slot signal ($\overline{U}_V$) and the second slot signal ($\overline{U}_V$), and a fourth digital value representative of the frequency $f$ of the excitation signal;

   wherein said digital circuit comprises:

   - a time-to-digital converter (TDC) for determining said third digital value ($\Delta\hat{T}$);
   - a calculation module for determining a first approximation ($\hat{\varphi}$) of said phase ($\hat{\varphi}$) from said third digital value ($\Delta\hat{T}$) and a fourth digital value representative of a frequency $f$ of said first and second analog signals;
   - a lookup table for determining a phase correction term ($-\Delta\varphi_{LH}$) based on the first and second digital values; and
   - an adder module for determining said estimate ($\hat{\varphi}'$) of said phase of the complex impedance of the electrical element by calculating the sum of said first approximation and said phase correction term.

7. Apparatus according to claim 6, also comprising a third digital-to-analog converter (ADC3) for generating a fifth digital value ($V_{LH}$) representative of a threshold voltage common to said first and second Schmitt triggers, said lookup table (LUT) being configured to determine said phase correction term ($-\Delta\varphi_{LH}$) based on the first, second, and fifth digital values.

8. Apparatus according to one of claims 6 or 7, wherein said digital circuit (CN) is also configured to receive as input said fifth digital value ($V_{LH}$).

[Fig. 1]

[Fig. 2]

[Fig. 3]

[Fig. 4]

[Fig. 5]

[Fig. 6]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3009086

**Littérature non-brevet citée dans la description**

- **L. ANGRISANI** ; **L. FERRIGNO**. Reducing the uncertainty in realtime impedance measurements. *Measurement*, 2001, vol. 30 (4), 307-315

- **JENS SCHRÖDER** ; **STEFFEN DOERNER** ; **THOMAS SCHNEIDER** ; **PETER HAUPTMANN**. Analogue and digital sensor interfaces for impedance spectroscopy. *Measurement Science and Technology*, 2004, vol. 15 (7), 1271-1278